# EUROPÄISCHE PATENTSCHRIFT

(11) **EP 2 860 151 B1**
(45) Veröffentlichungstag und Bekanntmachung des Hinweises auf die Patenterteilung: **11.09.2019**
(21) Anmeldenummer: 14003448.9
(22) Anmeldetag: 07.10.2014
(51) Int. Cl.: B81C 1/00

(54) **Verfahren zum Herstellen einer hybriden Mikro-Nano-Struktur sowie nach diesem Verfahren hergestellte Struktur**
Method for producing a hybrid micro-nano structure and structure made according to this method
Procédé de fabrication d'une micro-nano structure hybride et structure fabriquée selon ce procédé

(30) Priorität: 14.10.2013 DE 102013017018
(43) Veröffentlichungstag der Anmeldung: 15.04.2015
(73) Patentinhaber: Siegert Thinfilm Technology GmbH, 07629 Hermsdorf (DE)
(72) Erfinder: Müller, Lutz, 98693 Illmenau (DE); Hoffmann, Martin, 98704 Langewiesen (DE)
(74) Vertreter: Bartels und Partner, Patentanwälte

(56) Entgegenhaltungen:
- WO-A2-2012/088209
- LUTZ MÜLLER DIPL.-ING ET AL.: "Silicium-Platin Nanostrukturen für hochgradig Infrarot-emissive Oberflächen in Hotplate-Emittern Silicon-Platinum nanostructures for high emissive surfaces in infrared hotplate emitters", MIKROSYSTEMTECHNIK KONGRESS 2013 14.-16. OKTOBER 2013 IN AACHEN, 16. Oktober 2013 (2013-10-16), XP002735996, ISBN: 978-3-8007-3555-6 Gefunden im Internet: URL:https://www.tu-ilmenau.de/fileadmin/me dia/mms/Publikationen/_Mue13__MST-Kongress .pdf [gefunden am 2015-02-13]

## Beschreibung

Die Erfindung betrifft ein Verfahren zum Herstellen einer Struktur. Die Erfindung betrifft des Weiteren eine Struktur in Form einer Mikro-Nano-Struktur.

Die hier angesprochenen Strukturen in Form von Mikro-Nano-Strukturen sollen für hochgradig infrarot-emissive Oberflächen in sog. Hotplate-Emittern eingesetzt werden. Infrarotquellen werden für viele infrarotbasierte Messsysteme, wie Gas- oder Fluidsensoren, benötigt. Die Anforderungen an diese IR-Strahler sind dabei vielfältig. Ein breitbandiges Spektrum und eine über die gesamte Lebensdauer stabile Charakteristik werden für empfindliche Messungen benötigt. In der Mikrotechnik werden dafür häufig thermische membran-basierte IR-Emitter benutzt, die fachsprachlich auch als Micro-Hotplate-Emitter bezeichnet werden.

Nachteilig für hierfür eingesetzte silicium-basierte Membransysteme ist ein durch Interferenzen überlagertes Abstrahlspektrum (vgl. hierzu HILDEN-BRAND, Jürgen, et al.: Fast transient temperature operating micromachined emitter for mid-infrared optical gas sensing systems. In: Microsystem Technologies, 6 (2010), Nr. 5, S. 745-754. Und SPANNHAKE, Jan: Hochtemperaturstabile Mikroheizer für miniaturisierte Sensorsysteme. Ilmenau, Diss., 2009.). Da Silicium für Strahlung mit Wellenlängen oberhalb von ca. 1100 Nanometer transparent ist, wird der größte Anteil der emittierten Strahlung nicht durch das Silicium, sondern durch den Heizer hervorgerufen. Durch den hohen Brechzahlsprung von Silicium zu Luft wird ein Teil der innerhalb der Silicium-Membran transmittierten Strahlung an der Grenzfläche reflektiert (Fresnel-Verluste) und verursacht durch Mehrfachreflexion für spektrometrische Aufgaben störende Interferenzen. Antireflex-Beschichtungen für breitbandige Entspiegelungen sind teuer und in ihrer Bandbreite begrenzt. Hinzu kommt die geringe Emissivität der heizenden Metallstrukturen, was zu einer geringen Effizienz der Emitter führt.

Es existieren zwar einige Lösungen zur Steigerung der Emissivität von Oberflächen in Mikrosystemen, wobei regelmäßig sog. Platinruß als hochemissive Beschichtung in IR-Emittern bereits kommerziell eingesetzt wird, wobei hier spezielle Verdampfungsprozesse oder galvanische Abscheideverfahren zum Einsatz kommen (vgl. hierzu Produktdatenblatt der Axetris AG, Schweiz; Download von http://www.axetris.com/pdf/Axetris_Infrared_Sources_F60_ENG.pdf, 22.04.13. Und JASEK, Krzysztof, et al.: Platinum-black coating for infrared emitters. In: Optoelectronic and Electronic Sensors V, Proceedings of the SPIE, Bd. 5124 (2003), S. 92-95). Nachteilig ist hierbei, dass während der Verdampfung das gesamte Substrat sowie die Prozesskammer mit Rußpartikeln kontaminiert ist, was diesen Prozess für die Integration in Standard-Prozessabläufen weitgehend als untauglich erscheinen lässt. Auch die galvanische Abscheidung ist technisch aufwendig durchzuführen und kein Standardprozess der ansonsten gut beherrschten Mikro-Abscheidetechnik.

Die angesprochenen Beschichtungen, wie auch andere Lösungen zur Emissivitätssteigerung (YOUNKIN, Rebecca, et al.: Infrared absorption by cönical silicon microstructures made in a variety of background gases using femtosecond laser pulses. In: Journal of Applied Physics, Bd. 93 (2003), S. 2626. Und FENG, Guojin, et al.: Greatly enhanced infrared normal spectral emissivity of microstructured silicon using a femtosecond laser. In: Materials Letters, Bd. 65 (2011), Nr. 8, S. 1238-1240.), weisen zudem eine begrenzte Temperaturbeständigkeit auf. Bereits weit unterhalb der Schmelztemperatur rekristallisieren die feinen Metall-Nano-Strukturen und verschlechtern ihre absorbierenden Eigenschaften (vgl. MÜLLER, Lutz, et al.: Silicium-Metall Nanostrukturen mit ultrahoher Absorption im infraroten Strahlungsbereich. In: 4. GMM Workshop Mikro-Nano-Integration, 2012.). Die mangelnde Temperaturbeständigkeit steht in starkem Kontrast zu den Anforderungen an leistungsfähige thermische Emitter. Das letztgenannte Dokument offenbart auch ein Verfahren zum Herstellen einer Struktur mit mindestens einem ersten Strukturteil bestehend aus Silicium-Mikrostrukturen, wobei auf den Silicium-Mikrostrukturen Metall-Nanostrukturen als ein zweiter Strukturteil angeordnet werden.

Die WO 2012/088209 A2 beschreibt ein Verfahren zum Herstellen einer Struktur in Form einer Mikro-Nano-Struktur mit mindestens einem ersten Strukturteil, das zumindest teilweise derart mit einem weiteren Strukturteil versehen wird, das eine Oberfläche erhalten wird.

Ausgehend von diesem Stand der Technik liegt der Erfindung die Aufgabe zugrunde, ein Verfahren zum Herstellen einer Struktur nebst der Struktur selbst zur Verfügung zu stellen, die den Erhalt einer Struktur-Oberfläche ermöglicht, die neben einer hohen Emissivität, insbesondere im infraroten Strahlungsbereich, eine hohe Stabilität gegen mechanische und/oder thermische und/oder durch Kontaktmedien hervorgerufene Beanspruchung aufweist.

Diese Aufgabe löst ein Verfahren mit den Verfahrensschritten des Patentanspruchs 1 sowie eine Struktur mit den Merkmalen des Patentanspruchs 7.

Das erfindungsgemäße Verfahren zum Herstellen einer Struktur mit mindestens einem ersten Strukturteil bestehend aus Silicium-Mikrostrukturen, sieht vor, dass auf den Silicium-Mikrostrukturen Metall-Nanostrukturen als ein zweiter Strukturteil angeordnet werden und danach als weiterer Strukturteil eine Dünnfilm-Beschichtung aus Siliciumdioxid (SiO₂), Siliciumoxinitrid (Si-OₓN_{y}), Siliciumnitrid (Si₃N₄), Aluminiumoxid (Al₂O₃), Kalziumflorid (CaF₂) oder deren Kombinationen aufgebracht wird.

Das erfindungsgemäße Verfahren ist dadurch charakterisiert, dass das erste Strukturteil zumindest teilweise derart mit einem weiteren Strukturteil bestehend aus Silicium, Aluminium oder Kalzium aufweisenden Beschichtungsmaterialien versehen wird, dass eine Oberfläche erhalten wird, die neben einer hohen Emissivität, insbesondere im infraroten Strahlungsbereich, eine hohe Stabilität gegen mechanische und/oder thermische und/oder durch Kontaktmedien hervorgerufene Beanspruchung aufweist, und dass zwischen dem ersten und dem weiteren Strukturteil ein zweites Strukturteil angeordnet wird, das aus Metall-Nano-Strukturen besteht, welche aufgrund ihrer geometrischen Ausprägung mittels dem weiteren Strukturteil derart passiviert werden, dass eine Rekristallisation der Metall-Nano-Strukturen verhindert wird.

Insbesondere wird durch das angesprochene Verfahren eine neuartige Kombination aus Silicium-Mikrostrukturen und Platin-Nano-Strukturen erhalten, welche sich mittels Standard-Technologien im Bereich der Mikro-Systemtechnik fertigen und durch eine nachfolgende SiO₂-Beschichtung derart passivieren lässt, dass eine hochemissive und hochtemperaturstabile Oberfläche für Hotplate-Emitter zur Verfügung steht. Des Weiteren entsteht mit der angesprochenen Struktur, insbesondere unter Einbezug ihrer Oberfläche, eine besonders wirksame Antireflexschicht im IR-Bereich, die sich auch als Filterschicht sinnfällig verwenden lässt. Sofern im Stand der Technik Si-Nano-Strukturen als Antireflexschichten und Filterschichten im IR-Bereich bereits eingesetzt werden, sind die dahingehenden Oberflächen ausgesprochen abriebempfindlich, so dass diese weder mechanisch kontaktiert werden dürfen, noch ist eine Reinigung der genannten Oberfläche von Verschmutzungen möglich. Mit der erfindungsgemäßen Verfahrens-Lösung ist erreicht, dass man optische Nano-Strukturen durch Dünnfilm-Beschichtungsverfahren in optisch transparente Materialien einbetten kann, ohne dass der optische Effekt der Nano-Mikro-Struktur verloren geht. Für transparente optische Bereiche, bei denen die Nano-Strukturen als Antireflexschicht oder Filterschicht genutzt werden, sind die Si-Nano-Strukturen mit Siliciumdioxid (SiO₂), Siliciumoxinitrid (SiOₓN_{y}), Siliciumnitrid (Si₃N₄), Aluminiumoxid (Al₂O₃), Kalziumflorid (CaF₂) oder deren Kombinationen beschichtet, wodurch eine deutliche Verbesserung der Abriebfestigkeit und mithin Beständigkeit erzielt wird.

Bei einer besonders bevorzugten Ausführungsform des erfindungsgemäßen Verfahrens werden die Metall-Nano-Strukturen des zweiten Strukturteils aus Platin-Materialien gebildet.

Die angesprochenen Silicium-Platin-Strukturen bilden im Gegensatz zu dem Platin-Ruß (auch Platin-Moor genannt) keine schwammartige Struktur aus. Insbesondere bei hohen Temperaturen und bei entsprechender Beanspruchung erweist sich die schwammartige Grundstruktur aller auf Metall-Ruß basierenden Systeme als wenig stabil.

Die gerichtete Struktur der Silicium-Nadeln als erstes Strukturteil mit darauf aufgedampften, vielen kleinen Platin-Nadeln als zweites Strukturteil ermöglicht eine Beschichtung mittels Niedertemperatur-Plasmaabscheidung von temperaturstabilen Materialien, wie Siliciumdioxid, Siliciumoxinitrid oder Siliciumnitrid als drittem Strukturteil. Das abgeschiedene dritte Strukturteil-Material umschließt dabei die Nano-Strukturen vollständig und verhindert so die strukturelle Veränderung der Metallnadeln bei hohen Temperaturen. Gleichzeitig hat das Siliciumdioxid aufgrund seiner geringen Brechzahl und hohen Transparenz im Infraroten praktisch keinen Einfluss auf die optischen Eigenschaften der Silicium-Platin-Strukturen. Dadurch behalten die Silicium-Platin-Strukturen ihre guten emittierenden Eigenschaften auch bei Temperaturen weit über 450 °C bei. Des Weiteren können alle Prozessschritte auf Standard-Prozessen der Mikrosystemtechnik basieren, was das eingesetzte Verfahren besonders prozesssicher und kostengünstig macht. Es liegt noch im Bereich der Erfindung, anstelle von dem angesprochenen reinen Siliciummaterial für das dritte Strukturteil andere Materialien einzusetzen, wie beispielsweise amorphes, polykristallines oder dotiertes Silicium, SiliciumDioxid, Germanium, Aluminium-Oxid sowie keramische- und Kunststoff (Polycarbonat)-Grundkörper. Das erste Strukturteil in der Art eines Trägers kann bevorzugt die Form eines Wafers haben; es besteht aber auch die Möglichkeit der Realisierung in Form anderer Trägergeometrien, beispielsweise auch in Drahtform. Neben Platin kommen für das zweite Strukturteil weitere Metalle in Frage, wie beispielsweise Wolfram, Palladium etc., die bevorzugt eine geringe Oxidation aufweisen und ansonsten "stabil" sind.

Weitere vorteilhafte Ausgestaltungen des erfindungsgemäßen Verfahrens sowie der danach hergestellten Struktur sind Gegenstand der sonstigen Ansprüche.

Im Folgenden wird das erfindungsgemäße Verfahren nebst der Struktur anhand von Ausführungsbeispielen nach der Zeichnung näher erläutert. Dabei zeigen in prinzipieller und nicht maßstäblicher Darstellung die
- Fig. 1: in Form einer REM-Aufnahme teilweise in Ansicht, teilweise in Schnittdarstellung mittels Deep Reactive Ion Etching (DRIE) geätzte Silicium-Mikrostrukturen in Form von mit Rippeln versehenen Nadeln; fachsprachlich auch mit Silicium-Gras bezeichnet;
- Fig. 2: eine der Fig. 1 entsprechende REM-Aufnahme von geätzten Silicium-Mikrostrukturen (Silicium-Gras) mit zusätzlicher Platin-Beschichtung als zweitem Strukturteil;
- Fig. 3: eine der Fig. 2 entsprechende REM-Aufnahme des Querschnitts von geätzten Silicium-Mikrostrukturen (Silicium-Gras) mit zusätzlicher Platin-Beschichtung (Bedampfung) und anschließendem Tempern bei 800 °C;
- Fig. 4: eine REM-Aufnahme des Querschnitts von geätzten SiliciumMikrostrukturen (Silicium-Gras) als erstem Strukturteil nach der Fig. 1 mit zusätzlicher Platin-Beschichtung als zweitem Strukturteil nach der Fig. 2 und anschließender Beschichtung mit Siliciumdioxid als drittem Strukturteil;
- Fig. 5: in vereinfachter Darstellung einen Prozessablauf zur Herstellung von IR-Emittern mit mikrostrukturierter Oberfläche; und
- Fig. 6: in der Art eines Diagramms verschiedene Messergebnisse betreffend den Absorptionsgrad von verschieden ausgebildeten Struktur-Oberflächen, aufgetragen über der Wellenlänge in Nanometern.

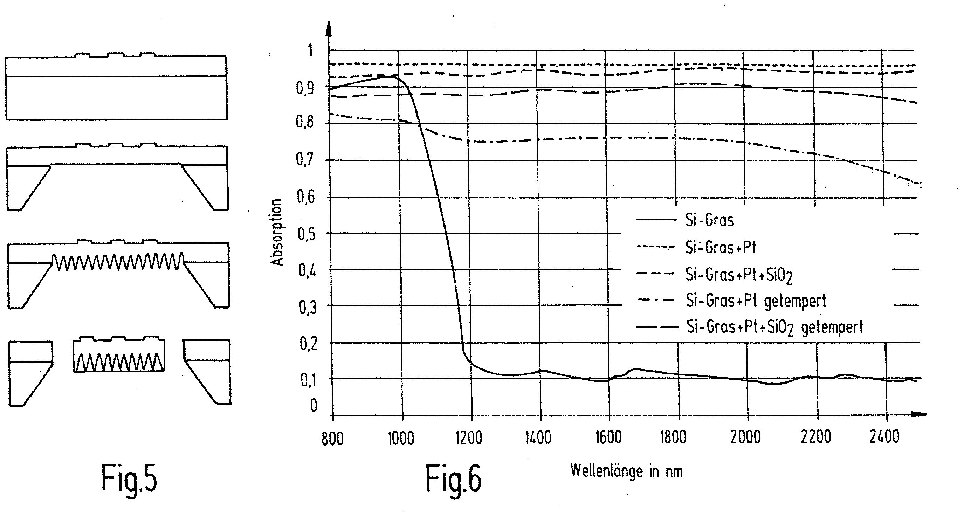

Im Folgenden wird anhand der Fig. 5 ein vereinfachter Prozessablauf zur Herstellung von IR-Emittern mit der erfindungsgemäßen mikrostrukturierten Oberfläche näher erläutert. Zunächst erfolgt in üblicher Weise das Abscheiden und die Strukturierung des metallischen Heizers auf einem SOI-Substrat (s. oberste Darstellung). In einem zweiten Schritt (s. nachfolgende, zweite Darstellung) erfolgt KOH-Ätzen der Membran und Entfernen der SiO₂-Schicht. Die Basis der absorbierenden Si-Pt-Strukturen bilden mittels Deep Reactive Ion Etching (DRIE) geätzte Silicium-Mikrostrukturen gemäß dem nachfolgenden dritten Verfahrensbild und anschließend erfolgt gemäß diesem dritten Verfahrensbild die Platinbeschichtung mittels Verdampfung.

Der angesprochene DRIE-Prozess ist derart angepasst, dass die Dauer des Passivierungsschrittes gegenüber der Dauer des Ätzschrittes erhöht wird.

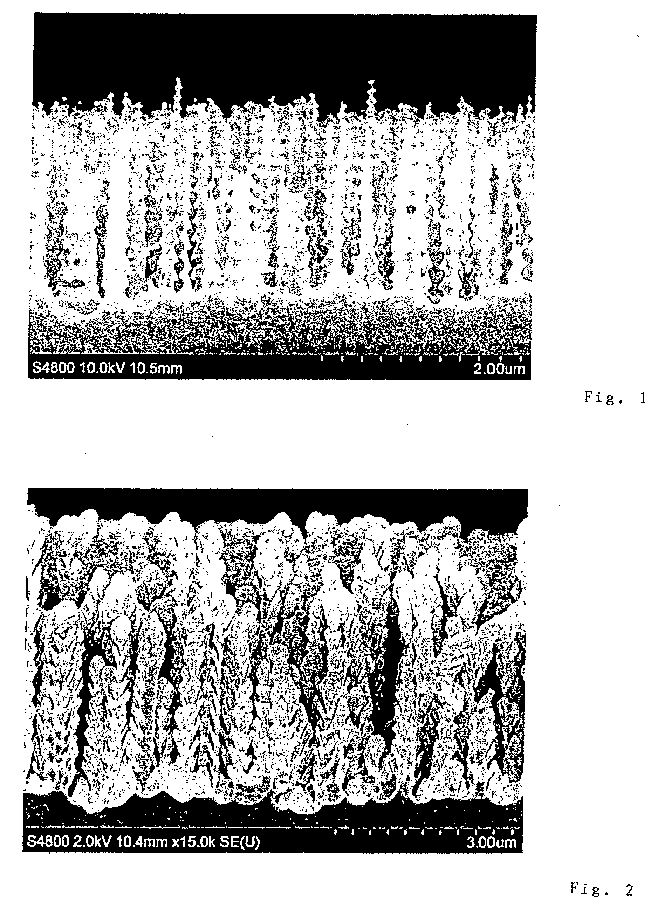

Dadurch wird die Passivierung im Ätzschritt auf horizontalen Flächen nicht vollständig entfernt und bildet eine nichtperiodische, clusterartige Nanomaskierung. Diese Maskierung resultiert im Laufe der weiteren Ätzzyklen in einer nadelförmigen Siliciumstruktur, welche als REM-Bild in Fig. 1 dargestellt ist. Die Fig. 1 zeigt dabei des Weiteren auch die spezielle Seitenwandstruktur der Siliciumnadeln in Form sog. Bosch-Rippel auf.

Das Herstellen derartig geätzter Siliciumnadeln, wie in Fig. 1 vorgestellt, ist Stand der Technik (vgl. LEOPOLD, Steffen, et al.: Formation of silicon grass - Nanomasking by carbon clusters in cyclic deep reactive ion etching. In: Journal of Vacuum Science & Technology, Bd. 29 (2011), S. 011002. Und LEOPOLD, Steffen, et al.: Online monitoring of the passivation breakthrough during deep projective ion etching of silicon using optical plasma emission spectroscopy. In: Journal of Micromechanics and Microengineering, Bd. 23 (2013), Nr. 7, S. 074001.).

Das Ätzen der Silicium-Mikrostrukturen (Silicium-Gras) in Silicium-Oberflächen als erstem Strukturteil kann auch mit vorstrukturierten Silicium-Oberflächen erfolgen. Als verwendeter Anlagentyp für das Ätzen kommt bevorzugt eine Inductive Coupled Plasma (ICP)-Ätzanlage zum Einsatz. Charakterisiert ist das Ätzverfahren unter anderem auch dadurch, dass keine Lithographie zur Nadelerzeugung zwingend nötig ist; jedoch können Bereiche mit Nadeln per Lithographie definiert werden. Grundsätzlich ist ein sog. zyklischer Ätzprozess einzusetzen, damit die Seitenwände der Nadeln die typischen Rippel aufweisen. Die Rippel sind nötig, um das spätere Wachstum der Platin-Kristalle an dieser Vorstruktur zu erleichtern.

Im Anschluss werden diese Silicium-Strukturen mittels Elektronenstrahlverdampfung mit Platin beschichtet. Dazu werden, im Gegensatz zu Platin-Moor-Prozessen, Prozessparameter genutzt, wie sie auch für die Abscheidung von planaren Schichten verwendet werden. Durch die spezielle Seitenwandstruktur der Siliciumnadeln (Bosch-Rippel) wachsen einzelne Platin-Kristallite an den Flanken der Siliciumstrukturen als zweites Strukturteil gemäß der REM-Bilddarstellung nach der Fig. 2 an. Sofern das Metall, hier Platin, denkbar sind jedoch auch andere Metalle, wie beispielsweise Wolfram, Gold, Nickel, Palladium etc., mittels Verdampfung aufgebracht wird, bewegen sich die jeweiligen Metallteilchen ohne Kollision untereinander geradlinig zum zu beschichtenden Substrat und können dort als zweites Strukturteil durch Abschattungseffekte (bedingt durch die Rippel der Si-Nadeln) als diskrete Nanokristalle aufwachsen. Insgesamt können für den angesprochenen Verdampfungsprozess aus der Mikrosystemtechnik bekannte normale Schichtabscheideverfahren genutzt werden. Nur dort, wo sich auf dem Substrat als erstem Strukturteil Si-Nadeln befinden, entstehen auch die Metall-Nanokristalle. Dort, wo das Substrat "flach" ist, wird einfach eine normale glatte Metallschicht, hier in Form einer Platinschicht, abgeschieden; dies stellt einen großen prozesstechnischen Vorteil dar gegenüber den bekannten Abscheideverfahren von Platin-Ruß. Zusammenfassend bleibt festzuhalten, dass ähnlich dem Prinzip der "oblique angle deposition" (OAD) (vgl. SUZUKI, Motojumi: Practical applications of thin films nanostructured by shadowing growth. In: Journal of Nanophotonics, Bd. 7 (2013), Nr. 1, S. 073598.) die Einzelkristallite durch Abschattung im Falle der Siliciumnadeln initial durch die starken Seitenwandstrukturen derselben entstehen.

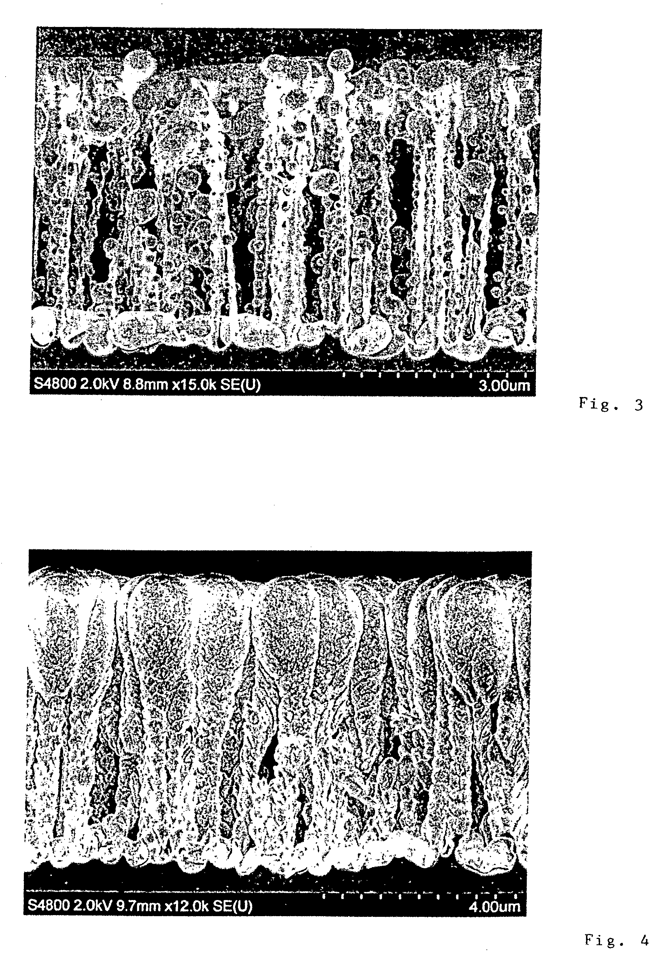

Die in Fig. 2 dargestellte REM-Struktur mit Siliciumnadeln, die mit Platin beschichtet sind, zeigt bereits ein hervorragendes Absorptionsverhalten. Bei einem Einsatz unter hohen Temperaturen, wie sie typischerweise bei thermischen Emittern gewünscht sind, unterliegen die Platinstrukturen jedoch, wie alle nanoskaligen Strukturen, einem Rekristallisations- und Umordnungsprozess. Fig. 3 zeigt eine dahingehende REM-Aufnahme einer Silicium-Platin-Struktur nach einer Erhitzung für die Dauer von zwei Stunden auf 800 °C, was an sich weit unterhalb der Schmelztemperatur von Platin (=1768 °C) liegt. Die feinen, nadelförmigen Einzelkristallite sind gemäß der Darstellung nach der Fig. 3 vollständig zu größeren Konglomeraten umstrukturiert und durch diese Strukturänderung hat die in Fig. 3 gezeigte Struktur keine hohen Emissions- bzw. Absorptionswerte mehr, was jedoch für den Einsatz der erfindungsgemäßen Struktur im Rahmen von Antireflexschichten, IR-Filtern und IR-Emittern sowie IR-Sensorschichten zwingend notwendig ist.

Um demgemäß die unerwünschte Umstrukturierung zu größeren Konglomeraten zu verhindern, wird die Struktur, bestehend aus erstem und zweitem Strukturteil, nach der Fig. 2 mittels eines üblichen Chemical Wafer Deposition - Verfahrens (CVD) mit dem temperaturstabilen Material SiO₂ als drittem Strukturteil beschichtet, wodurch sich eine funktionsgemäße REM-Struktur nach der Fig. 4 ergibt. Das Freistellen der Membran und die angesprochene Beschichtung sind in der Bildabfolge nach der Fig. 5 zuunterst dargestellt.

Im Gegensatz zu den schwammartigen Metall-Ruß-Beschichtungen, wie sie im Stand der Technik aufgezeigt sind, erlauben die Silicium-Platin-Strukturen eine Beschichtung mit SiO₂ als dritter Strukturlage über die gesamte weitere Struktur mit erster und zweiter Strukturlage. Wird die vollendete Struktur nach der Fig. 4 ebenfalls bei 800 °C getempert, lässt sich mittels REM kein struktureller Unterschied feststellen. Die Pt-Strukturen als zweites Strukturteil sind fest in der SiO₂-Matrix gebunden und können insoweit keine energetisch günstigere Form mehr annehmen.

Sofern als dritte Strukturlage Beschichtungsmaterialien zum Einsatz kommen, wie SiO₂, SiOₓ, SiNₓ usw., entsteht eine Beschichtungslage, die transparent für Infrarotstrahlung ist. Als weitere Plasma-Abscheideverfahren kommen in Frage "Inductive Coupled Plasma Enhanced Chemical Vapor Deposition" (ICPCVD) oder PECVD (keine zusätzliche ICP-Quelle). Vorzugsweise läuft der Abscheideprozess mit konformer Abscheidecharakteristik bei relativ niedrigen Temperaturen ab, um ein vorzeitiges Rekristallisieren der Pt-Strukturen als zweitem Strukturteil zu verhindern.

Es steht nach der Erfindung zu erwarten, dass Pt-Strukturen mit einer Länge zwischen ca. 400 nm und 600 nm die größten Absorptionsgrade zeigen. Bei kürzeren Platinnadeln steigt die Transmission durch die Si-Pt-Strukturen, während bei größeren Platinnadeln die Reflexion an der zunehmend dichteren Oberfläche zunimmt. In beiden Fällen sinkt die effektive Absorption von Strahlung. Zur messtechnischen Charakterisierung und zur weiteren Darstellung der erfindungsgemäßen Lösung wurden Proben mit unterschiedlicher Oberflächenstrukturierung und Beschichtung hergestellt. Die unterschiedlich strukturierten Proben wurden mit einem dispersiv arbeitenden Spektrometer und einer sog. Ulbrichtkugel vermessen (Cary 5000 mit DRA 2500 von Varian). Dabei wurden in zwei verschiedenen Messungen zunächst die hemisphärische Gesamttransmission (diffuse und spekulare Anteile) sowie die spektrale hemisphärische Gesamtreflexion (diffuse und spekulare Anteile) erfasst. Aus diesen beiden Größen lässt sich nach Maxwell mit A = 1 - (R + T) der Absorptionsgrad A berechnen. Die spektralen Absorptionsgrade der einzelnen Proben S1 bis S5 sind dabei in Fig. 6 dargestellt. An der Probe S1 (Silicium Gras), die im Sinne der Erfindung ein erstes Strukturteil nach der Fig. 1 darstellt, lässt sich sehr gut die Antireflexionswirkung von mikrostrukturierten Oberflächen erkennen. Während das Silicium für Wellenlängen oberhalb von ca. 1100 nm nahezu transparent ist, beträgt die Absorption für kleinere Wellenlängen über 90 %. Bei polierten Oberflächen läge dieser Wert aufgrund von Fresnel'schen Reflexionsverlusten unterhalb von 70 %. Dagegen zeigen die Proben S2 und S3, die ein erstes Strukturteil bedampft mit dem zweiten Strukturteil in Form von Platin betreffen bzw. eine dahingehende Struktur, die mit einem dritten Strukturteil beschichtet ist in Form von SiO₂, über den gesamten messbaren Bereich sehr hohe Absorptionsgrade von ca. 0,97 bzw. 0,95 auf. Die zusätzliche Beschichtung mit SiO₂ als drittem Strukturteil bewirkt demnach nur eine vernachlässigbare Verschlechterung der Absorption durch zusätzliche Reflexionsverluste.

Nach der Erhitzung der Proben auf 800 °C weist die nur mit Platin beschichtete Probe S4 jedoch eine deutliche Verringerung ihrer Absorption von 20 % bis 30 % auf, was auf die starke Formänderung der Platinstrukturen (vgl. Fig. 3) und die damit verbundene Erhöhung des Reflexionsgrades (hier nicht dargestellt) zurückzuführen ist. Im Gegensatz dazu weist die zusätzlich mit SiO₂ als drittem Strukturteil passivierte Probe S5 nach der Erhitzung nur eine geringe Absenkung des Absorptionsgrades auf ca. 0,95 bis 0,93 auf. Dies ist nach bisheriger Kenntnis der höchste mögliche Wert für mikrostrukturierte Oberflächen für Temperaturen bis 800 °C. Insgesamt bleibt festzuhalten, dass mit der erfindungsgemäßen Strukturlösung sich eine hohe Emissivität (>97 %) bei gleichzeitiger Temperaturstabilität (> 800 °C) erreichen lässt. Ferner lässt sich die dahingehende Struktur vollständig mittels herkömmlicher Standardtechnologie der Mikrosystemtechnik herstellen.

## Patentansprüche

1. Verfahren zum Herstellen einer Struktur mit mindestens einem ersten Strukturteil bestehend aus Silicium-Mikrostrukturen, wobei auf den Silicium-Mikrostrukturen Metall-Nanostrukturen als ein zweiter Strukturteil angeordnet werden und dadurch charakterisiert dass danach als weiterer Strukturteil eine Dünnfilm-Beschichtung aus Siliciumdioxid (Si02), Siliciumoxinitrid (SiOₓN_{y}), Siliciumnitrid (Si₃N₄), Aluminiumoxid (Al₂O₃), Kalziumflorid (CaF₂) oder deren Kombinationen aufgebracht wird.

2. Verfahren nach Anspruch 1, **dadurch gekennzeichnet, dass** die Metall-Nano-Strukturen des zweiten Strukturteils aus Platin-Materialien gebildet werden.

3. Verfahren nach Anspruch 1 oder 2, **dadurch gekennzeichnet, dass** das erste Strukturteil durch Ätzen eines Silicium-Bauteils erhalten wird unter Bildung von einzelnen Nadeln, deren Oberflächen eine Strukturierung, insbesondere in Form von Rippeln, aufweisen.

4. Verfahren nach Anspruch 3, **dadurch gekennzeichnet, dass** die Dauer der Ätz- und Passivierungszyklen derart verschoben wird, dass die Silicium-Nadeln durch Selbstmaskierung entstehen.

5. Verfahren nach einem der vorstehenden Ansprüche, **dadurch gekennzeichnet, dass** für den Erhalt des zweiten Strukturteils das erste Strukturteil als Mikrostruktur mit einem Metall, insbesondere in Form von Wolfram, Palladium, vorzugsweise jedoch in Form von Platin, als Nano-Struktur beschichtet wird, bevorzugt durch Verdampfen des jeweiligen Metalls auf das erste Strukturteil.

6. Verfahren nach einem der vorstehenden Ansprüche, **dadurch gekennzeichnet, dass** für den Erhalt des weiteren dritten Strukturteils eine Beschichtung mit einem temperaturstabilen, für Infrarotstrahlung transparenten Material, wie beispielsweise SiOₓ, SiNₓ auf die beiden anderen Strukturteile, vorzugsweise in Form der Si-Pt-Struktur vorgenommen wird.

7. Struktur herstellbar mit einem Verfahren nach einem der vorhergehenden Ansprüche mit einem ersten Strukturteil bestehend aus Silicium-Mikro-Strukturen, auf dem als zweiter Strukturteil Metall-Nanostrukturen angeordnet sind und mit einer Dünnfilm-Beschichtung aus Siliciumdioxid (SiO₂), Siliciumoxinitrid (SiOₓN_{y}), Siliciumnitrid (Si₃N₄), Aluminiumoxid (Al₂O₃), Kalziumflorid (CaF₂) oder deren Kombinationen als weiterem Strukturteil.

8. Struktur nach Anspruch 7, **dadurch gekennzeichnet, dass** die Metall-Nano-Strukturen des zweiten Strukturteils aus Platin-Materialien gebildet sind.

9. Struktur nach Anspruch 7 oder 8, **dadurch gekennzeichnet, dass** das erste Strukturteil eine Vielzahl von einzelnen vorstehenden Nadeln aufweist, deren Oberfläche eine Mikro-Strukturierung, insbesondere in Form von Rippeln, hat.

10. Struktur nach einem der Ansprüche 7 bis 9, **dadurch gekennzeichnet, dass** das zweite Strukturteil aus einem Metall gebildet ist, insbesondere in Form von Wolfram, Palladium, vorzugsweise in Form von Platin, die eine Nano-Struktur ausbilden.

## Claims

1. Method for producing a structure with at least one first structure part consisting of silicon microstructures, wherein metal nanostructures are arranged on the silicon microstructures as a second structure part, and **characterised in that**, as a further structure part, a thin-film layer of silicon dioxide (SiO₂), silicon oxynitride (SiOₓN_{y}), silicon nitride (Si₃N₄), aluminium oxide (Al₂O₃), calcium fluoride (CaF₂) or combinations thereof are applied.

2. Method according to claim 1, **characterised in that** the metal nanostructures of the second structure part are formed from platinum materials.

3. Method according to claim 1 or 2, **characterised in that** the first structure part is obtained by etching a silicon component part with the formation of individual needles, the surfaces of which exhibit a structuring, in particular in the form of ripples.

4. Method according to claim 3, **characterised in that** the duration of the etching and passivation cycles is delayed in such a way that the silicon needles are formed by self-masking.

5. Method according to any of the preceding claims, **characterised in that**, for the obtaining of the second structure part, the first structure part is coated with a metal, in particular in the form of tungsten, palladium, but preferably in the form of platinum, as a nanostructure, preferably by evaporating the respective metal onto the first structure part.

6. Method according to any of the preceding claims, **characterised in that**, for the obtaining of the further third structure part, a coating is carried out with a temperature-stable material which is transparent to infrared radiation, such as SiO_{X}, SiN_{X}, onto the two other structure parts, preferably in the form of the Si-Pt structure.

7. Structure which can be produced with a method according to any of the preceding claims, with a first structure part consisting of silicon microstructures, on which, as a second structure part, metal nanostructures are arranged, and with a thin-film coating of silicon dioxide (SiO₂), silicon oxynitride (SiOₓN_{y}), silicon nitride (Si₃N₄), aluminium oxide (Al₂O₃), calcium fluoride (CaF₂) or combinations thereof as the further structure part.

8. Structure according to claim 7, **characterised in that** the metal nanostructures of the second structure part are formed from platinum materials.

9. Structure according to claim 7 or 8, **characterised in that** the first structure part comprises a plurality of individual projecting needles, the surface of which has a microstructuring, in particular in the form of ripples.

10. Structure according to any one of claims 7 to 9, **characterised in that** the second structure part is formed from a metal, in particular in the form of tungsten, palladium, and preferably in the form of platinum, which form a nanostructure.

## Revendications

1. Procédé de fabrication d'une structure ayant au moins une première partie de structure en microstructures de silicium, dans lequel on met sur les microstructures de silicium des nanostructures de métal comme deuxième partie de la structure et **caractérisé en ce qu'**ensuite on dépose comme autre partie de la structure un revêtement en couche mince de dioxyde de silicium (SiO₂), d'oxynitrure de silicium (SiOₓN_{y}) de nitrure de silicium (Si3N4), d'oxyde d'aluminium (Al2O3), de fluorure de calcium (CaF2) ou de leurs combinaisons.

2. Procédé suivant la revendication 1, **caractérisé en ce que** l'on forme les nanostructures de métal de la deuxième partie de structure en matériau de platine.

3. Procédé suivant la revendication 1 ou 2, **caractérisé en ce que** l'on obtient la première partie de structure par attaque d'une pièce en silicium avec formation d'aiguilles individuelles, dont les surfaces ont une structuration, notamment sous la forme de nervures.

4. Procédé suivant la revendication 3, **caractérisé en ce que** l'on décale les durées des cycles d'attaque et de passivation, de manière à créer les aiguilles de silicium par automasquage.

5. Procédé suivant l'une des revendications précédentes, **caractérisé en ce que** pour obtenir la deuxième partie de la structure, on revêt la première partie de la structure comme microstructure d'un métal, notamment sous la forme de tungstène, de palladium, de préférence toutefois sous la forme de platine, comme nanostructure, de préférence par dépôt en phase vapeur du métal respectif sur la première partie de structure.

6. Procédé suivant l'une des revendications précédentes, **caractérisé en ce que** pour obtenir l'autre troisième partie de la structure, on effectue un revêtement par un matériau stable à la température et transparent au rayonnement infrarouge, comme par exemple SiOₓ, SiNₓ sur les deux autres parties de la structure, de préférence sous la forme de la structure Si-Pt.

7. Structure pouvant être fabriquée par un procédé suivant l'une des revendications précédentes, comprenant une première partie de structure en des microstructures de silicium, sur laquelle est mise comme deuxième partie de la structure des nanostructures de métal et comprenant un revêtement en couche mince de dioxyde de silicium (SiO₂), d'oxynitrure de silicium (SiOₓN_{y}), de nitrure de silicium (Si3N4), d'oxyde d'aluminium (Al₂O₃), de fluorure de calcium (CaF₂) ou de leurs combinaisons comme autre partie de la structure.

8. Structure suivant la revendication 7, **caractérisée en ce que** les nanostructures de métal de la deuxième partie de la structure sont en des matières de platine.

9. Structure suivant la revendication 7 ou 8, **caractérisée en ce que** la première partie de la structure a une pluralité d'aiguilles individuelles en saillie, dont la surface a une microstructuration, notamment sous la forme de nervures.

10. Structure suivant l'une des revendications 7 à 9, **caractérisée en ce que** la deuxième partie de la structure est en un métal, notamment sous la forme de tungstène, de palladium, de préférence sous la forme de platine, qui constitue une nanostructure.
